# DEMANDE DE BREVET EUROPEEN

(11) **EP 1 189 277 A1**
(43) Date de publication de la demande: **20.03.2002**
(21) Numéro de dépôt: 01402287.5
(22) Date de dépôt: 04.09.2001
(51) Int. Cl.: H01L 23/14

(54) **Substrat pour circuit électronique et module électronique utilisant un tel substrat**

(30) Priorité: 15.09.2000 FR 0011802
(71) Demandeur: Alstom, 75116 Paris (FR)
(72) Inventeur: Boursat, Benoit, 64320 Bizanos (FR); Dutarde, Emmanuel, 65800 Aureilhan (FR); Meysenc, Luc, 65600 Semeac (FR); Saiz, José, 33150 Cenon (FR); Solomalala, Pierre, 65800 Aureilhlan (FR)
(74) Mandataire: Gosse, Michel

(57) **Abrégé**

Substrat pour circuit électronique, caractérisé en ce qu'il comporte une tranche (1) en silicium Si dont la face supérieure est recouverte d'une couche électriquement isolante (3) en nitrure de silicium SiN, ladite couche électriquement isolante (3) en nitrure de silicium supportant une ou plusieurs pistes conductrices (4) obtenues par métallisation de la face supérieure de ladite couche électriquement isolante (3) et destinées à permettre la connexion d'un ou plusieurs composants électroniques (5).

## Description

L'invention se rapporte à un substrat pour circuit électronique, notamment pour circuit électronique de puissance, et plus particulièrement à un substrat destiné à supporter une différence de potentiel entre des pistes conductrices disposées sur la face supérieure du substrat et un système de refroidissement accolé à la face inférieure du substrat, tout en assurant un bon échange thermique. Le substrat selon l'invention est destiné à supporter des composants passifs, des composants semi-conducteurs de puissance, et notamment des transistors bipolaires à grilles isolée dits IGBT, utilisés dans les circuits de distribution d'énergie du domaine ferroviaire et dans le domaine du transport d'énergie pour lesquels les valeurs de tension sont particulièrement importantes.

Il est connu de l'art antérieur d'avoir des substrats pour circuit électronique de puissance comportant une tranche électriquement isolante en nitrure d'aluminium AlN recouverte sur ses faces inférieure et supérieure d'une métallisation de cuivre d'une épaisseur d'environ 300 µm par un procédé dénommé DBC (Direct Bonding Copper). Pour améliorer le refroidissement, un radiateur est habituellement accolé à la couche de cuivre inférieure afin d'évacuer la chaleur dégagée par les composants de puissance.

Un tel substrat comporte une tranche électriquement isolante en nitrure d'aluminium AlN possédant une très bonne conductivité thermique mais présente toutefois l'inconvénient d'avoir des couches d'accroche, formée, par le procédé DBC à l'interface entre la tranche en AlN et les métallisations de cuivre, constituant une barrière thermique réduisant considérablement les capacités de transmission de chaleur du substrat. De plus, la différence importante de coefficient de dilatation thermique entre le nitrure d'aluminium AlN (4,2 µm/m) et le cuivre (16,4 µm/m) et la variation importante de température, de 70°C à 110°C, selon le fonctionnement des composants de puissances provoquent des contraintes mécaniques à l'intérieur du substrat, et surtout aux interfaces pouvant provoquer à terme la rupture du substrat.

Le but de la présente invention est donc de proposer un nouveau type de substrat destiné à recevoir des composants électroniques, et notamment des semi-conducteurs de puissance, qui permette de pallier les inconvénients de l'art antérieur évoqués ci-dessus et qui soit simple et économique à réaliser.

A cet effet, l'invention a pour objet un substrat pour circuit électronique caractérisé en ce qu'il comporte une tranche en silicium Si dont la face supérieure est recouverte d'une couche électriquement isolante en nitrure de silicium SiN, cette dernière supportant une ou plusieurs pistes conductrices obtenues par métallisation de la face supérieure de la couche électriquement isolante et destinées à permettre la connexion d'un ou plusieurs composants électroniques.

Selon des modes particuliers de réalisation, le substrat pour circuit électronique peut comprendre l'une ou plusieurs des caractéristiques suivantes prises isolément ou selon toutes les combinaisons techniquement possibles :
- une couche en oxyde de silicium SiO₂ est interposée entre la tranche en silicium et la couche isolante en nitrure de silicium, la couche en oxyde de silicium SiO₂ possédant une faible épaisseur et servant de couche d'accroche pour le dépôt de la couche isolante en nitrure de silicium sur une épaisseur plus importante ;
- au moins l'un des composants électroniques montés sur le substrat est un composant semi-conducteur de puissance ;
- la couche électriquement isolante nitrure de silicium est une structure multicouche composée de différents types de nitrures de silicium comportant successivement des couches tensives et compressives de telle sorte que les contraintes sur la tranche en silicium se compensent ;
- les différentes couches de nitrure de silicium de la couche électriquement isolante sont essentiellement obtenues par dépôt chimique en phase vapeur assisté par plasma PECVD ;
- au moins une couche de nitrure de silicium composant la couche électriquement isolante est obtenue par dépôt chimique en phase vapeur à basse pression LPCVD ;
- la métallisation de la piste conductrice est obtenue par croissance électrolytique de cuivre ;
- la face inférieure de la tranche en silicium comporte des stries formant des canaux sur lesquels s'écoule un fluide de refroidissement ;
- la face inférieure de la tranche en silicium est recouverte d'une couche d'oxyde de silicium et d'une couche électriquement isolante en nitrure de silicium.

L'invention concerne également un module électronique caractérisé en ce qu'il comporte au moins un composant électronique monté sur un substrat conforme aux caractéristiques précédemment décrites.

On comprendra mieux les buts, aspects et avantages de la présente invention, d'après la description donnée ci-après de plusieurs modes de réalisation de l'invention, présentés à titre d'exemple non limitatif, en se référant aux dessins annexés, dans lesquels :
- la figure 1 est une vue schématique, en coupe, d'un substrat selon l'art antérieur ;
- la figure 2 est une vue schématique, en coupe, d'un substrat selon un premier mode réalisation de l'invention ;
- la figure 3 est une vue schématique, en coupe, d'un module puissance utilisant le substrat de la figure 2 ;
- la figure 4 est une vue schématique, en coupe, d'un second mode de réalisation du substrat selon l'invention.

Pour faciliter la lecture du dessin, seuls les éléments nécessaires à la compréhension de l'invention ont été représentés. Les mêmes éléments portent les mêmes références d'une figure à l'autre.

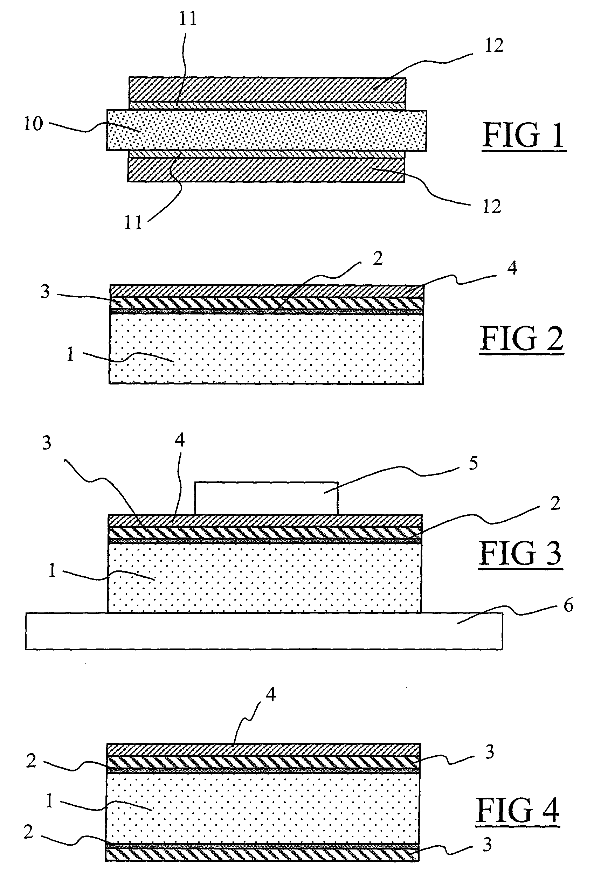

La figure 1 représente un substrat selon l'art antérieur comportant une tranche électriquement isolante 10 en nitrure d'aluminium AlN d'une épaisseur de 635 µm recouverte sur ses faces inférieure et supérieure d'une feuille de cuivre 12. Les feuilles de cuivre 12, d'une épaisseur d'environ 300 µm, sont déposées par un procédé DBC (Direct Bonding Cooper) consistant à amener les feuilles de cuivres 12 sur la tranche 10 en AlN et à monter l'ensemble à très haute température pour créer une couche d'accroche 11 d'une épaisseur de l'ordre 5 µm à l'interface entre les feuilles 12 de cuivre et la tranche 10 en nitrure d'aluminium. Dans un tel substrat, la feuille de cuivre 12 supérieure est utilisée pour réaliser des pistes conductrices destinées à recevoir des composants de puissances et la feuille de cuivre 12 inférieure sert à compenser les contraintes générées par la dilatation différentielle entre la feuille de cuivre 12 supérieure et la tranche 10 en AlN afin d'éviter une déformation du substrat.

Conformément au tableau suivant, un tel substrat possède un coefficient d'échange thermique totale entre ses deux faces extérieure de l'ordre de 10⁻⁵ W/m²K dans lequel la couche d'accroche 11 représente 50% du coefficient d'échange thermique totale du substrat.

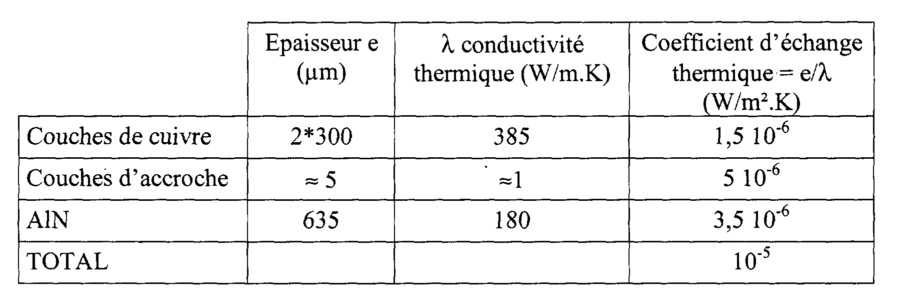

La figure 2 représente un substrat selon un mode particulier de réalisation de l'invention. Conformément cette figure, le substrat comporte une tranche 1 en silicium Si d'une épaisseur de 500 µm dont la face supérieure est recouverte d'une couche 2 d'oxyde de silicium SiO₂. Cette couche 2 d'oxyde de silicium SiO₂, d'une épaisseur de l'ordre de 0,05 µm, est obtenue par oxydation de la face supérieure de la tranche 1 en silicium par un procédé de croissance dans un four avec injection d'oxygène ou de vapeur d'eau. Un tel procédé conduisant à l'oxydation de l'ensemble des faces de la tranche 1 en silicium, la couche d'oxyde de la face inférieure de la tranche 1 est éliminée par gravure. Bien entendu, un procédé permettant d'obtenir directement une couche d'oxyde de silicium sur une seule pourra également être utilisé.

La couche 2 d'oxyde de silicium SiO₂ de la face supérieure de la tranche 1 en silicium est utilisée comme surface d'accroche pour le dépôt d'une couche électriquement isolante 3 en nitrure de silicium SiN. Cette couche électriquement isolante 3 est constituée d'une structure multicouche de différents nitrures de silicium avantageusement déposés par un procédé de dépôt chimique en phase vapeur assisté par plasma PECVD.

Les différentes couches de nitrure de silicium sont déposées successivement en modifiant entre chaque couche le paramétrage de la torche à plasma, et notamment la fréquence du plasma, de manière à obtenir une alternance de couches tensives, générant des contraintes tendant à rendre concave le substrat, avec des couches compressives, générant des contraintes tendant à bomber le substrat. La structure multicouche ainsi crée permet d'obtenir une épaisseur de la couche électriquement isolante 3 en nitrure de silicium de l'ordre de 10 µm permettant d'isoler des tensions de 10 à 20 kV, sans générer des contraintes trop importantes sur la tranche 1 en silicium afin d'éviter la rupture de cette dernière. Bien entendu, l'épaisseur de la couche isolante 3 en nitrure de silicium sera d'autant plus importante que la tension à laquelle est soumise le substrat est importante.

Dans une variante de réalisation, la structure multicouche pourra également comporter une couche en nitrure de silicium pur Si3N4 obtenue par un procédé de dépôt chimique en phase vapeur à basse pression LPCVD. Une telle couche présente l'avantage d'être dotée d'une meilleure tension de claquage que le nitrure de silicium obtenu par le procédé PECVD. La couche en nitrure de silicium pur ainsi obtenue est une couche tensive générant de très fortes contraintes tendant à rendre concave le substrat et sera donc recouverte d'une couche compressive en nitrure de silicium obtenue par le procédé PECVD afin d'obtenir une compensation des contraintes s'exerçant sur la tranche 1 en silicium et ne pas provoquer sa rupture.

La face supérieure de la couche électriquement isolante 3 en nitrure de silicium est recouverte d'une couche de cuivre 4, d'une épaisseur de l'ordre de 150 µm, réalisée par croissance électrolytique. Cette couche de cuivre 4 est utilisée pour constituer une ou plusieurs pistes conductrices destinées à recevoir un composant de puissance 5 tel qu'un composant IGBT ainsi que cela est représenté sur la figure 3.

La face inférieure du substrat est accolée à un radiateur de refroidissement 6 permettant d'évacuer la chaleur dégagée par le composant IGBT 5 et transmise au travers du substrat. Dans une variante de réalisation non représentée, le radiateur de refroidissement pourra être directement intégré au substrat en réalisant sur la face inférieure de la tranche 1 de silicium des stries formant des canaux dans lesquels s'écoule un fluide de refroidissement.

Conformément au tableau suivant, un tel substrat possède un coefficient d'échange thermique totale entre les deux faces de l'ordre de 4,1 10⁻⁶ W/m².K.

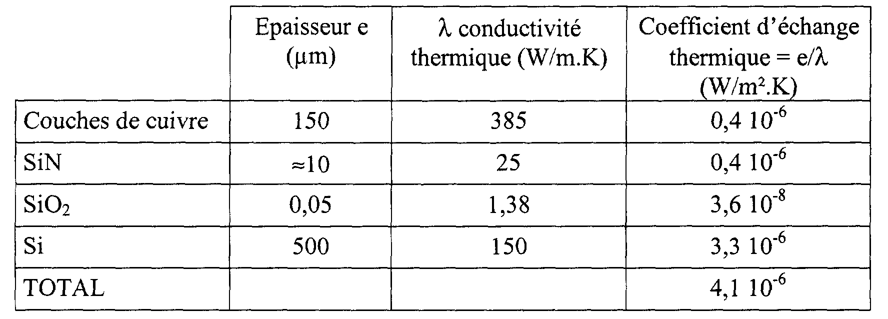

Un tel substrat présente l'avantage d'avoir une structure très homogène avec une couche d'accroche en SiO₂ d'une très faible épaisseur possédant une très faible résistance thermique, ne pénalisant pas les performances globales du substrat. Par ailleurs, cette couche d'oxyde de silicium SiO₂ contribue à absorber une partie des contraintes générées par la couche isolante en nitrure de silicium et permet donc, pour une même contrainte sur la tranche de silicium, d'augmenter l'épaisseur de la couche isolante en nitrure de silicium.

Le substrat selon l'invention présente également l'avantage de posséder des coefficients de dilatation thermique de la tranche de silicium (CTE= 2,5 µm/m) et de la couche électriquement isolante en nitrure de silicium (CTE =3 µm/m) très proches de celui des composants de puissances montés sur le substrat ce qui a pour conséquence de réduire considérablement les contraintes thermomécaniques et donc d'augmenter la fiabilité des modules de puissance utilisant un tel substrat. Cette bonne concordance des coefficients de dilatation thermique des différentes couches du substrat avec les puces de puissances est particulièrement avantageuse pour supporter l'emploi des nouveaux composants de puissance en carbure de silicium SiC, pour lesquels la température de fonctionnement sera de l'ordre de 150°C, en conservant une fiabilité thermomécanique acceptable malgré l'augmentation des contraintes thermomécaniques par rapport aux composants de puissance fonctionnant habituellement à 110°C.

La figure 4 représente un second mode de réalisation du substrat selon l'invention dans laquelle la tranche en silicium 1 est recouverte sur ses deux faces d'une couche 2 d'oxyde de silicium SiO₂ et d'une couche électriquement isolante 3 formée d'une structure multicouche en nitrure de silicium SiN. Les couches 2 et 3 des deux faces sont obtenues par des procédés similaires à ceux décrient dans le mode de réalisation précédent.

Une telle variante de réalisation, en conservant le dépôt sur les deux faces de la tranche de silicium, présente l'avantage de simplifier la réalisation du substrat, le procédé de dépôt de la couche d'oxyde de silicium par croissance dans un four ainsi que le procédé de dépôt de la couche en nitrure de silicium SiN par dépôt chimique en phase vapeur à basse pression LPCVD conduisant naturellement à un dépôt sur les deux faces de la tranche de silicium. Cette simplification du procédé de fabrication du substrat par le dépôt sur les deux faces de la tranche de silicium ne pénalise pas trop la conductivité thermique globale du substrat grâce à la bonne conductivité thermique des couches d'oxyde de silicium et de nitrure de silicium.

Bien entendu, l'invention n'est nullement limitée aux mode de réalisation décrits et illustrés qui n'ont été donné qu'à titre d'exemple.

Ainsi, le substrat selon l'invention trouve une application avantageuse dans le domaine des circuits électroniques de puissance mais il peut également être utilisé pour supporter des composants électroniques passifs dans le domaine des circuits électroniques de type classique.

## Revendications

1. Substrat pour circuit électronique comportant une tranche (1) en silicium Si dont la face supérieure est recouverte d'une couche électriquement isolante (3) en nitrure de silicium SiN, ladite couche électriquement isolante (3) en nitrure de silicium supportant une ou plusieurs pistes conductrices (4) obtenues par métallisation de la face supérieure de ladite couche électriquement isolante (3) et destinées à permettre la connexion d'un ou plusieurs composants électroniques (5) **caractérisé en ce que** la couche électriquement isolante (3) en nitrure de silicium possède une structure multicouche, composée de différents types de nitrures de silicium, comportant successivement des couches tensives et compressives de telle sorte que les contraintes sur la tranche (1) en silicium se compensent.

2. Substrat pour circuit électronique selon la revendication 1, **caractérisé en ce qu'**une couche (2) en oxyde de silicium SiO₂ est interposée entre ladite tranche (1) en silicium et ladite couche isolante (3), ladite couche (2) en SiO₂ possédant une faible épaisseur et servant de couche d'accroche pour le dépôt de ladite couche isolante (3) en nitrure de silicium sur une épaisseur plus importante.

3. Substrat pour circuit électronique selon l'une quelconque des revendications 1 à 2, **caractérisé en ce qu'**au moins l'un desdits composants électroniques (5) est un composant semi-conducteur de puissance.

4. Substrat pour circuit électronique de puissance selon l'une quelconque des revendications 1 à 3, **caractérisé en ce que** les différentes couches de nitrure de silicium de la couche électriquement isolante sont essentiellement obtenues par dépôt chimique en phase vapeur assisté par plasma PECVD.

5. Substrat pour circuit électronique de puissance selon l'une quelconque des revendications 1 à 4, **caractérisé en ce qu'**au moins une couche de nitrure de silicium composant la couche électriquement isolante (3) est obtenue par dépôt chimique en phase vapeur à basse pression LPCVD.

6. Substrat pour circuit électronique de puissance selon l'une quelconque des revendications 1 à 5, **caractérisé en ce que** la métallisation de la piste conductrice (4) est obtenue par croissance électrolytique de cuivre.

7. Substrat pour circuit électronique de puissance selon l'une quelconque des revendications 1 à 6, **caractérisé en ce que** la face inférieure de la tranche en silicium (1) comporte des stries formant des canaux sur lesquels s'écoule un fluide de refroidissement.

8. Substrat pour circuit électronique de puissance selon l'une quelconque des revendications 1 à 7, **caractérisé en ce que** la face inférieure de la tranche (1) en silicium est recouverte d'une couche d'oxyde de silicium (2) et d'une couche électriquement isolante (3) en nitrure de silicium.

9. Module électronique, **caractérisé en ce qu'**il comporte au moins un composant électronique monté sur un substrat selon l'une quelconque des revendications 1 à 8.
